**Europäisches Patentamt**

**European Patent Office**

**Office européen des brevets**

(11) Publication number: **0 194 634**

**A2**

# EUROPEAN PATENT APPLICATION

(21) Application number: **86103187.0**

(51) Int. Cl.⁴: **H05H 1/34**

(22) Date of filing: **10.03.86**

(30) Priority: **14.03.85 US 711681**

(43) Date of publication of application:
**17.09.86 Bulletin 86/38**

(84) Designated Contracting States:
**CH DE FR GB IT LI**

(71) Applicant: **THE PERKIN-ELMER CORPORATION**
**761 Main Avenue**
**Norwalk Connecticut 06859-0074(US)**

(72) Inventor: **Freund, Fritz F.**
**12 Allenby Drive**
**Fort Salonga New York 11768(US)**
Inventor: **Wolf, Philip C.**
**7 Salem Ridge Drive**
**Huntigton New York 11743(US)**

(74) Representative: **Patentanwälte Grünecker, Kinkeldey,**
**Stockmair & Partner**
**Maximilianstrasse 58**
**D-8000 München 22(DE)**

(54) **Plasma gun nozzle with extended life.**

(57) A copper anode nozzle for a plasma gun is disclosed, in which the inner arc-striking surface of the nozzle bore has a thin coating thereon. The coating is formed of a material such as titanium nitride and must be oxidation resistant and have good electrical conductivity. The nozzle has reduced arc erosion resulting in prolonged operational life.

*FIG. 1*

EP 0 194 634 A2

## PLASMA GUN NOZZLE WITH EXTENDED LIFE

The present invention relates to the field of plasma spray guns and particularly to a plasma spray gun nozzle with a thin refractory coating of the nozzle bore which increases the nozzle life over that previously achieved with prior art designs.

Background of the Invention

In typically plasma flame spraying systems, an electrical arc is created between a water cooled nozzle (anode) and a centrally located cathode. An inert gas passes through the electrical arc and is excited thereby to temperatures of up to 30,000°F. The plasma of at least partially ionized gas issuing from the nozzle resembles an open oxyacetylene flame. One such plasma flame spray gun is described in U.S. Patent No. 4,445,021.

The electrical arc of such plasma spray guns, being as intense as it is, causes nozzle deterioration and ultimate failure. Once cause for such deterioration is the fact that the arc itself strikes the nozzle at a point, thereby causing instantaneous melting and vaporizing of the nozzle surface. Deterioration is also caused by overheating the nozzle to the melting point so that part of the nozzle material flows to another location which may eventually cause the nozzle to become plugged.

There are varying degrees and rates associated with each cause of nozzle deterioration. Experience has shown that wall erosion, ultimately causing the coolant to burst through the nozzle wall, is another cause of nozzle failure. When the jacket bursts, coolant water is released into the arc region, resulting in a locally intense electric arc, causing parts to melt. Once a meltdown has occurred, gun repair can be very costly. The nozzle deterioration and failure problem is particularly severe at high power levels.

In seeking to overcome this problem, plasma spray guns have been designed with easily changed water cooled nozzles. During operation, water coolant is forced through passages in the nozzle to cool the nozzle walls. Even so, gradual, or sometimes rapid, deterioration occurs and, as a precaution against failure, the nozzles are usually replaced after a given number of hours of service. This practice of replacing the nozzle periodically, however, is quite costly because the interchangeable nozzles are fairly expensive and many nozzles with considerable life remaining are thereby discarded.

Many factors are involved in determining the rate of deteriorating and ultimate failure of a plasma spray gun nozzle. Copper is the common material of construction of a nozzle, apparently because of its high thermal and electrical conductivities. For the most part, nozzle operating conditions and geometry, gas type and flow rate, coolant flow rate and velocity influence the nozzle life, as well as does the nozzle cooling configuration.

An improvement in nozzle life was achieved by providing a nozzle with a nozzle wall and an adjacent thin annular coolant passage, the wall and passage having dimensions within certain narrow ranges, as disclosed in U.S. Patent No. 4,430,546. However, further improvements have continued to be highly desirable.

Another approach, described in U.S. Patent No. 2,941,063, is to provide a tubular tungsten liner in the arc region of the bore of a nozzle otherwise formed of copper. such a liner as shown in that patent and also utilized commercially is quite thick, generally several millimeters. Thick tungsten liners in commercial use have not been particularly successful in significantly increasing nozzle life.

Plating of copper nozzles with noble metals is described in U.S. Patent No. 3,578,943, where protection against reactive gases is required. The plating is with a metal such as gold or platinum and is applied to the outer portion of the nozzle where there is exposure to external corrosive gases. It is explicitly taught therein "that electrical contact of the nozzle with the plasma is preferably made by the copper surfaces (i.e., without a coating in the bore) so that the electrical resistance is not increased by the coating."

Therefore, the primary objective of the present invention is to provide an improved anode nozzle for a plasma spray gun having a prolonged operational life.

A further objective is to provide a novel anode nozzle which has a thin protective coating in the arc-striking region.

Brief Description of the Invention

The foregoing and other objectives are achieved according to the present invention by a copper anode nozzle for a plasma gun in which the inner arc-striking surface of the nozzle bore has a thin refractory coating thereon. The coating is formed of a material such as titanium nitride, having oxidation resistance and good electrical conductivity.

Brief Description of the Drawing

Fig. 1 is a longitudinal sectional view of a typical nozzle of a plasma spray gun coated according to the present invention.

Fig. 2 is a cutaway view of an arc deposition apparatus utilized for coating a nozzle according to the present invention.

Detailed Description of the Invention

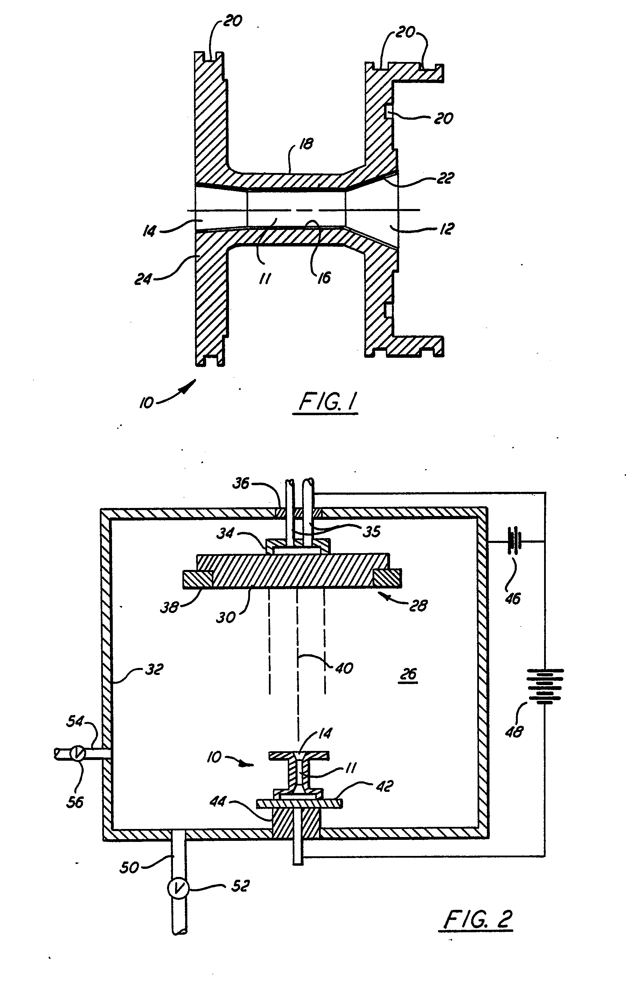

Fig. 1 illustrates an anode nozzle having, as an example, a configuration for fitting into a plasma gun of the type shown in aforementioned U.S. Patent No. 4,445,021. The nozzle 10 formed of high purity copper (99%), has a bore 11 therethrough which channels plasma forming gas, typically argon or nitrogen, from the inlet 12 through to the outlet 14 where it issues as plasma effluent after being heated by an arc. The high intensity arc is struck between a cylindrical cathode tip (not shown), which projects coaxially into the inlet, and the inner surface 16 of the nozzle bore.

Water coolant is directed over the outer surface 18 of the nozzle in the known or desired manner as, for example, in aforementioned U.S. Patent Nos. 4,445,021 and 4,430,546. O-rings (not shown) in suitable grooves 20 are provided as required for retaining the nozzle and sealing the coolant and the plasma forming gas in the gun.

According to the present invention a thin layer 22 of oxidation-resistant, electrically conductive material is coated on the inner surface 16 of the nozzle using any suitable method. The layer should be relatively thin, for example, between 1 micron and 100 microns, and preferably between 2 microns and 20 microns. (A disproportionately thick coating is shown in the drawing in order to depict the layer). The material should be stable, i.e., not melt, decompose or evaporate significantly, under the conditions of the high intensity arc striking the surface. Desirably the material should be refractory; as used herein and in the claims "refractory" means that the material is stable above about 2500°C. Electrical conductivity is necessary in order to conduct the high arc current (generally at least several hundreds of amperes) between the arc and the nozzle in its function as an anode. However the electrical conductivity may be intermediate, i.e., between that of an ordinary insulator such as alumina and that of a metal such as copper, as the coating apparently is thin enough for the arc current to traverse it into the copper of the nozzle.

The oxidation resistance of layer 22 at high temperature in air should be better than that of copper. Surprisingly, a nozzle coated with such a material has resulted in a quite significant increase in operational life under the high intensity arc and plasma generation. The mechanism of such improvement is not very well understood. It is speculated that, in spite of the fact that the plasma forming gas is inert, oxide films may develop on the inner surface of the nozzle. The arc then may selectively root at spots of oxide, thus concentrating the heat and accelerating deterioration. However, other theories may prove to be correct.

Examples of coating materials according to the present invention are refractory metals such as molybdenum, tantalum and tungsten; refractory borides such as borides of iron, hafnium, niobium, tantalum, titanium, tungsten and zirconium; refractory carbides such as carbides of boron, hafnium, molybdenum, niobium, silicon, tantalum, titanium, tungsten, vanadium and zirconium; refractory nitrides such as nitrides of boron, hafnium, niobium, silicon, tantalum, titanium, and zirconium; combinations of the aforementioned refractory materials such as tungsten-titanium carbide; and complex combinations of the aforementioned refractory materials such as titanium carbonitride, titanium borocarbide and zirconium boronitrides. Preferably the layer is formed of titanium nitride.

Layer 22 should cover the entire surface that the arc strikes. Since the arc generally moves or disperses over much of the bore, it is preferable that the layer coats the entire bore surface including the inlet and outlet sections - (14 and 16) as shown in the drawing. If the operating conditions of the gun cause the arc to be carried out to the front face 24 of the nozzle, as will be indicated by erosion on the face, the layer 22 should be extended over the front face.

A suitable and desirable process of producing the coating such as titanium nitride is by vacuum cathodic arc discharge physical vapor deposition ("arc deposition"). Such process and appropriate apparatus are described in detail in U.S. Patents Nos. 3,625,848, 3,793,179 and 4,430,184. In a typical embodiment shown in Fig. 2, a vacuum chamber 26 contains a beam gun 28 having a cathode 30 of target source material. The walls 32 of chamber 26 serve as the anode for the arc discharge to cathode 30. The cathode is mounted to the chamber with a system that includes a water coolant chamber 34 and ducts 35 connected to wall 32 with an insulator 36. A confinement ring 38 formed of boron nitride (as taught in U.S. Patent No. 4,430,184) confines the cathode spot of the arc to the target surface.

Nozzle 10 to be coated is placed in the beam path 40 of beam gun 28, typically about 10 cm from cathode 30, using an electrically conductive mounting 42 on a high voltage insulator bracket 44 extending through chamber wall 32. A vacuum is drawn through a conduit 50 connected to a vacuum pump (not shown). A valve 52 in the conduit is shut-off and the chamber is then backfilled with an appropriate gas such as nitrogen or argon through a pipe 54. Valve 56 in the pipe is turned off when the desired pressure is reached.

A low voltage (20-50 volts) d.c. source 46 of high current (100-200 amperes) is applied between the anode and cathode. The resulting arc discharge causes a beam of source material to be emitted with maximum concentration perpendicular to the cathode surface. The beam consists of primarily ions and some atoms. A high negative voltage - (200-500 volts) source 48 applied to nozzle 10 to be coated enhances deposition of the particles, particularly on such surfaces such as the nozzle bore 11 that are not facing directly at the source material.

For the production of titanium nitride coating in nozzle bore 11, according to the present invention by arc deposition, the nozzle bore was aligned with the outlet end 14 facing cathode 30. The cathode source used was a titanium disc about 10 cm in diameter. The chamber was backfilled to $10^{-3}$ millibar with nitrogen gas which reacted with the titanium during the deposition to produce the titanium nitride coating. The system was operated for about 15 minutes to produce a coating in bore surface 16 (Fig. 1) having a thickness between about 3 microns and about 5 microns. The nozzle coated had an overall length of 3.2 cm, a bore diameter of 0.63 cm, an inlet diameter of 1.28 cm and an exit diameter of 0.79 cm.

Although any other known or desired coating process may be utilized, it is necessary that the process be adapted to coat on the arc striking surface which, at least for a plasma spray gun, is normally inside the bore. Thus, for example, chemical vapor deposition may be used where the vapor is flowed through the bore under temperature and other conditions that cause deposition in the bore.

A nozzle coated as described above was tested in a plasma gun of the type described in aforementioned U.S. Patent No., 4,445,021 in comparison with an uncoated control nozzle. In a first phase of testing, each nozzle was operated for 12 hours (in one-hour increments) at 400 amperes and 60 to 65 volts using plasma gas at 2500 standard l/hr (100 SCFH). Inspection after the 12-hour test revealed visible erosion in the bore of the control nozzle and no visible erosion in the coated nozzle.

In a second phase of testing each of the same nozzles was run for an additional eight hours with hydrogen secondary gas added to the nitrogen primary plasma gas in an amount of 375 standard l/hr (15 SCFH), which increased the erosive conditions. The current was 400 amperes at 75 to 80 volts. Upon conclusion the control nozzle had considerable wear in the bore and at the intersection of the tapered inlet section and the cylindrical central section, the sharp edge having eroded away. Balls of copper were visible in the core. Portions of the bore were black in color. In contrast the coated nozzle had frosting around 300° of surface within the bore. One small section was unmarked and another section had two small pit marks.

While the invention has been described above in detail with reference to specific embodiments, various changes and modifications which fall within the spirit of the invention and scope of the appended claims will become apparent to those skilled in the art. The invention is therefore only intended to be limited by the appended claims or their equivalents.

**Claims**

1. An anode nozzle for a plasma gun, which is formed substantially of copper-like metal, has a plasma gas channel therein and has a surface portion that provides electrical contact for a plasma-forming arc, said surface portion having thereon a thin coating of a material characterized by sufficient oxidation resistance and sufficient electrical conductivity to prolong the operating life of said anode nozzle.

2. An anode nozzle according to Claim 1, wherein said surface portion defines at least part of said channel.

3. An anode nozzle according to Claim 1, wherein said coating material is stable above about 2500°C.

4. An anode nozzle according to Claim 1, wherein said coating material is selected from the group consisting of refractory metals, refractory borides, refractory carbides, refractory nitrides and combinations thereof.

5. An anode nozzle according to Claim 1, wherein said coating material is titanium nitride.

6. An anode nozzle according to Claim 4, wherein said coating material has a thickness between about 1 micron and about 100 microns.

7. An anode nozzle according to Claim 4, wherein said coating material is formed by a process of vacuum cathodic arc discharge physical vapor deposition.

8. An anode nozzle according to Claim 5, wherein said titanium nitride is formed by a process of vacuum cathodic arc discharge physical vapor deposition.

9. An anode nozzle for a plasma gun, which is formed substantially of copper and comprises an inner surface defining a channel for plasma gas flow, at least a portion of said inner surface providing electrical contact for a plasma forming arc current, said portion of said inner surface comprising a titanium nitride coating having a thickness between about 1 micron and about 100 microns.

_FIG. 1_

_FIG. 2_